# EUROPEAN PATENT APPLICATION

(11) **EP 4 772 348 A1**
(43) Date of publication of application: **08.07.2026**
(21) Application number: 24859935.9
(22) Date of filing: 29.08.2024
(51) Int. Cl.: B41J 2/14

(54) **LIQUID EJECTION HEAD, HEAD MODULE, AND RECORDING DEVICE**

(30) Priority: 31.08.2023 WO PCT/JP2023/031914
(71) Applicant: Kyocera Corporation, Kyoto-shi, Kyoto 612-8501 (JP)
(72) Inventor: HASHIMOTO, Mitsuhiro, Kyoto-shi, Kyoto 612-8501 (JP); YAMAGUCHI, Akifumi, Kyoto-shi, Kyoto 612-8501 (JP)
(74) Representative: Viering, Jentschura & Partner mbB Patent- und Rechtsanwälte
(86) International application number: PCT/JP2024/031068
(87) International publication number: WO 2025/047910

(57) **Abstract**

A liquid discharge head 1 includes a plurality of pressure chambers 31, a plurality of nozzles 21 respectively connected to the plurality of pressure chambers 31, a diaphragm 33 positioned on the plurality of pressure chambers 31, and a plurality of piezoelectric elements 34 positioned on the diaphragm 33 corresponding to the plurality of pressure chambers 31. The diaphragm 33 includes a first silicon oxide layer 331, a silicon layer 332 as a single layer positioned on the first silicon oxide layer 331 and having a thickness of 1.1 µm to 1.9 µm, and a second silicon oxide layer 333 positioned on the silicon layer 332 as a single layer.

## Description

### TECHNICAL FIELD

The present disclosure relates to a liquid discharge head, a head module, and a recording device.

### BACKGROUND OF INVENTION

A liquid discharge head that discharges liquid toward a recording medium is known. Such a liquid discharge head includes a plurality of pressure chambers, a plurality of nozzles respectively connected to the plurality of pressure chambers, a diaphragm positioned on the plurality of pressure chambers, and a plurality of piezoelectric elements positioned on the diaphragm corresponding to the plurality of pressure chambers. When a voltage is applied to the piezoelectric element, the piezoelectric element is displaced, and the diaphragm is displaced in accordance with the displacement of the piezoelectric element. By the displacement of the diaphragm, liquid in the pressure chamber is pressurized, and the liquid is discharged from the nozzle connected to the pressure chamber.

In Patent Document 1, an SOI (Silicon On Insulator) wafer is used as a material of the diaphragm, and a first silicon oxide layer and a second silicon oxide layer are formed on an upper surface and a lower surface of a silicon layer. Patent Document 1 discloses that a thickness of the silicon layer is 2 µm to 20 µm, and a thickness of each of the first silicon oxide layer and the second silicon oxide layer is 0.5 µm to 2.0 µm.

In Patent Document 2, an SOI wafer is used as a diaphragm, and a first silicon oxide layer and a second silicon oxide layer are formed on an upper surface and a lower surface of a silicon layer. Patent Document 2 discloses that a thickness of the silicon layer is 3 µm or more, a thickness of the first silicon oxide layer is 0.5 µm or more, and a thickness of the second silicon oxide layer is 0.5 µm or more.

### CITATION LIST

### PATENT LITERATURE

Patent Document 1: JP 2008-228458 A
Patent Document 2: JP 2019-161213 A

### SUMMARY

A liquid discharge head according to an aspect of the present disclosure includes a plurality of pressure chambers, a plurality of nozzles respectively connected to the plurality of pressure chambers, a diaphragm positioned on the plurality of pressure chambers, and a plurality of piezoelectric elements positioned on the diaphragm corresponding to the plurality of pressure chambers, wherein the diaphragm includes a first silicon oxide layer, a silicon layer as a single layer positioned on the first silicon oxide layer and having a thickness of 1.1 µm to 1.9 µm, and a second silicon oxide layer positioned on the silicon layer as a single layer.

### BRIEF DESCRIPTION OF THE DRAWINGS

FIG. 1 is a side view schematically illustrating a printer according to the present embodiment.
FIG. 2 is a plan view schematically illustrating the printer according to the present embodiment.
FIG. 3 is a plan view schematically illustrating a liquid discharge head according to the present embodiment.
FIG. 4 is a view of the liquid discharge head illustrated in FIG. 3, as seen from a direction A.
FIG. 5 is an enlarged view of a region I illustrated in FIG. 3.
FIG. 6 is a cross-sectional view taken along line II-II illustrated in FIG. 5.
FIG. 7 is a cross-sectional view taken along line III-III illustrated in FIG. 5.
FIG. 8 is a view illustrating a result of an evaluation experiment when a total thickness of a first silicon oxide layer and a second silicon oxide layer is 0.1 µm.
FIG. 9 is a view illustrating a result of the evaluation experiment when the total thickness of the first silicon oxide layer and the second silicon oxide layer is 0.2 µm.
FIG. 10 is a view illustrating a result of the evaluation experiment when the total thickness of the first silicon oxide layer and the second silicon oxide layer is 0.3 µm.
FIG. 11 is a view illustrating a result of the evaluation experiment when the total thickness of the first silicon oxide layer and the second silicon oxide layer is 0.4 µm.
FIG. 12 is a view illustrating a result of the evaluation experiment when the total thickness of the first silicon oxide layer and the second silicon oxide layer is 0.5 µm.
FIG. 13 is a view illustrating a result of the evaluation experiment when the total thickness of the first silicon oxide layer and the second silicon oxide layer is 0.6 µm.
FIG. 14 is a view illustrating an amount of displacement of a diaphragm.
FIG. 15 is an enlarged view of a region IV illustrated in FIG. 6.
FIG. 16 is an enlarged view of a region V illustrated in FIG. 7.
FIG. 17 is a block diagram illustrating a configuration example of a head module.

### DESCRIPTION OF EMBODIMENTS

Embodiments of the present invention will be described below with reference to the drawings.

Note that drawings used in the following description are schematic, and dimensional ratios and the like on the drawings do not always match the actual ones. In multiple drawings illustrating the same configuration, dimensional ratios and the like may not match each other in order to exaggerate shapes or the like.

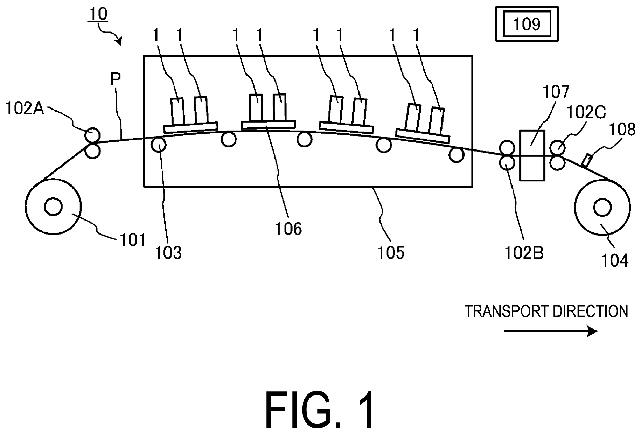

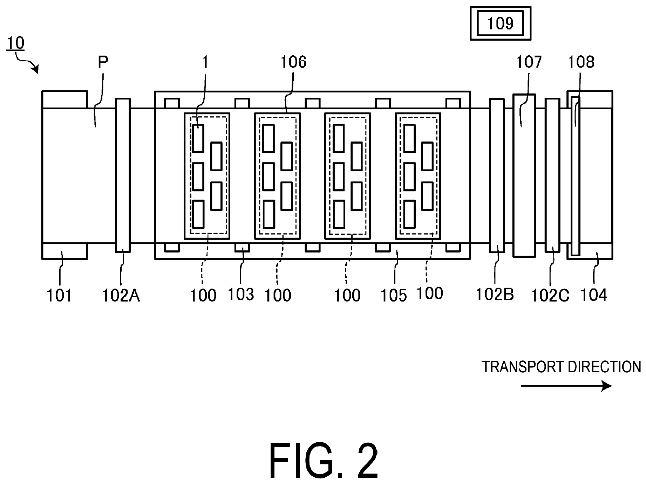

A configuration of a printer 10 according to the present embodiment will be described with reference to FIGs. 1 and 2.

FIG. 1 is a side view schematically illustrating the printer 10 including a liquid discharge head 1 according to the present embodiment. FIG. 2 is a plan view schematically illustrating the printer 10. The printer 10 is, for example, a color inkjet printer.

As illustrated in FIG. 1, the printer 10 includes a paper feed roller 101, guide rollers 102, transport rollers 103, a collection roller 104, a head case 105, frames 106, liquid discharge heads 1, a dryer 107, a sensor unit 108, and a controller 109.

The controller 109 controls operations of the paper feed roller 101, the guide rollers 102, the transport rollers 103, the collection roller 104, the head case 105, the frames 106, the liquid discharge heads 1, the dryer 107, the sensor unit 108.

The paper feed roller 101, the guide rollers 102, the transport rollers 103, and the collection roller 104 constitute a moving unit that relatively moves the printing paper P and the liquid discharge head 1. The printing paper P is an example of a recording medium. The moving unit is controlled by the controller 109. The printing paper P passes between two guide rollers 102A from the paper feed roller 101 and is transported onto the plurality of transport rollers 103. Thereafter, the printing paper P passes between two guide rollers 102B and between two guide rollers 102C and is transported to the collection roller 104.

The head case 105 accommodates the transport rollers 103, the frames 106, and the liquid discharge heads 1. The head case 105 is a space that is connected to the outside at a part such as a part where the printing paper P enters and exits but is separated from the outside. As necessary, for the internal space of the head case 105, control factors such as temperature, humidity, and air pressure are controlled by the controller 109.

The frames 106 have a flat plate shape and are positioned above and in close proximity to the printing paper P transported by the transport rollers 103. The four frames 106 are positioned at predetermined intervals along a transport direction of the printing paper P in the head case 105. The number of the frames 106 mounted on the printer 10 can be changed as appropriate in accordance with a printing target or printing conditions.

The liquid discharge head 1 has an elongated shape elongated in the vertical direction on the paper surface of FIG. 2. As illustrated in FIG. 2, five liquid discharge heads 1 are mounted on each frame 106. In each frame 106, five liquid discharge heads 1 constitute a head module 100. In each frame 106, three liquid discharge heads 1 are aligned along a direction intersecting the transport direction of the printing paper P, and the other two liquid discharge heads 1 are aligned one by one between the three liquid discharge heads 1 at positions shifted along the transport direction. In each frame 106, the liquid discharge heads 1 are arranged so as to overlap each other in the transport direction of the printing paper P. The number of the liquid discharge heads 1 included in one frame 106 can be changed as appropriate in accordance with a printing target or printing conditions. The moving unit relatively moves the printing paper P and the head module 100, thereby relatively moving the printing paper P and the liquid discharge heads 1.

In the present embodiment, the liquid discharge head 1 is fixed to the printer 10. That is, the printer 10 is a line printer. Note that the printer 10 is not limited to a line printer, and may be a so-called serial printer that alternately performs an operation of discharging liquid droplets while moving the liquid discharge heads 1 in a direction intersecting the transport direction of the printing paper P and transport of the printing paper P.

The controller 109 controls the liquid discharge heads 1 based on data of an image, characters, or the like to discharge the liquid toward the printing paper P. A distance between the liquid discharge head 1 and the printing paper P is, for example, about 0.5 to 20 mm.

The liquid discharge heads 1 belonging to one head module 100 are supplied with liquid of the same color, and therefore, the four head modules 100 can print four colors of liquids. Each head module 100 may be provided with a reservoir substrate positioned over the five liquid discharge heads 1. Thus, the liquid can be supplied to the five liquid discharge heads 1 from a channel of the reservoir substrate. The colors of the liquids discharged from the liquid discharge heads 1 of the respective head modules 100 are, for example, magenta, yellow, cyan, and black. By landing such liquids on the printing paper P, a color image can be printed. Note that the type of color of the liquid can be changed as appropriate. The liquid discharge head 1 belonging to one head module 100 may be configured to supply liquids of several kinds of colors and to print the liquids of several kinds of colors by one head module 100.

In addition to printing with colored liquids, in order to treat the surface of the printing paper P, a liquid such as a coating agent may be printed uniformly or patterned by the liquid discharge heads 1. Note that the coating agent may be applied from a coater (not illustrated), instead of the liquid discharge heads 1.

The dryer 107 dries the printing paper P. After passing between the two guide rollers 102B, the printing paper P is dried by the dryer 107. Drying with the dryer 107 suppresses adhesion at overlapped portions of the printing paper P wound around the collection roller 104 and rubbing of undried liquid.

The sensor unit 108 includes a position sensor, a speed sensor, and a temperature sensor. The controller 109 can control each portion of the printer 10 based on the information from each sensor.

The printer 10 may include a cleaner configured to clean the liquid discharge heads 1. The cleaner cleans the liquid discharge heads 1 by, for example, a wiping process or a capping process.

As the recording medium, in addition to the printing paper P, a roll of cloth or the like may be used. The printer 10 may transport the recording medium using a transport belt. In this way, a sheet of paper, cut cloth, wood, a tile, or the like can be used as the recording medium. In addition, by discharging liquid containing electrically conductive particles from the liquid discharge heads 1, for example, a wiring pattern of an electronic device may be printed. Chemicals may be fabricated by discharging a predetermined amount of liquid chemical agent or a liquid containing a chemical agent from the liquid discharge heads 1 toward a reaction vessel or the like and causing it to react.

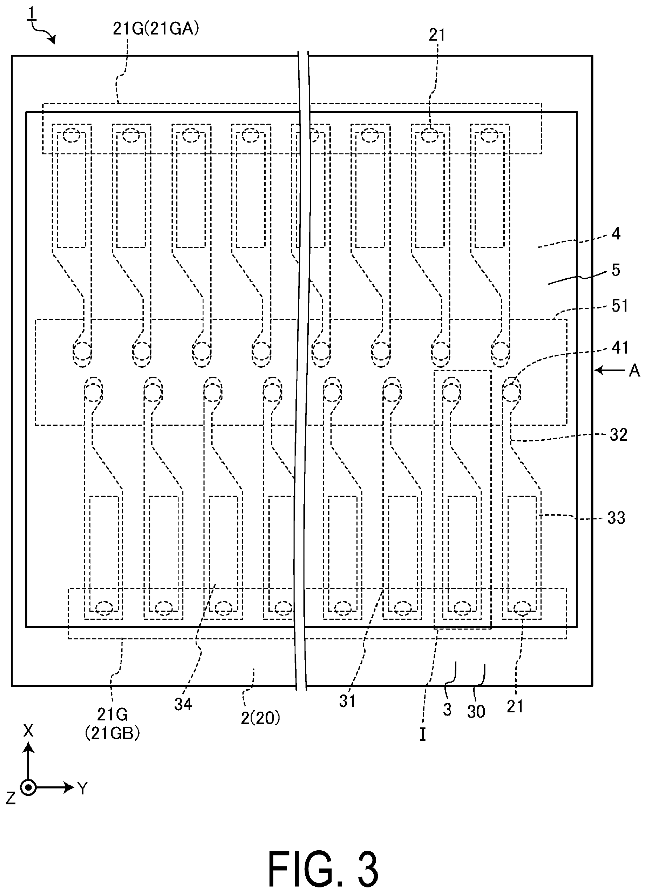

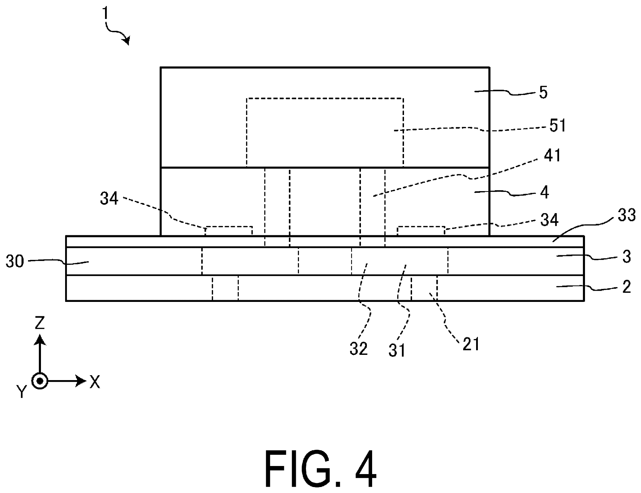

The configuration of the liquid discharge head 1 according to the present embodiment will be described with reference to FIGs. 3 and 4. FIG. 3 is a plan view schematically illustrating the liquid discharge head 1 according to the present embodiment. FIG. 4 is a side view of the liquid discharge head 1 illustrated in FIG. 3, as seen from a direction A. Note that in FIG. 3, two wavy lines illustrated in the vertical direction on the paper surface represent omitted lines.

Note that for ease of understanding the description, FIG. 3 illustrates a three-dimensional orthogonal coordinate system including the X axis in which an upward direction on the paper surface is a positive direction and the Y axis in which a rightward direction on the paper surface is a positive direction. Such an orthogonal coordinate system is also presented in the other drawings used in the description below. In the following description, the Z axis positive direction side in the liquid discharge head 1 may be referred to as "above (on)" for convenience. Note that in the liquid discharge head 1, the X axis direction is the transport direction of the printing paper P.

The liquid discharge head 1 includes a nozzle member 2, an actuator member 3, a support member 4, and a liquid supply member 5.

The nozzle member 2 includes a plurality of nozzles 21. The nozzle member 2 is formed of silicon.

The plurality of nozzles 21 are through holes penetrating the nozzle member 2 in the Z axis direction. The plurality of nozzles 21 are positioned along the Y axis direction and form nozzle groups 21G. The nozzle groups 21G according to the present embodiment include a first nozzle group 21GA on the X axis positive direction side and a second nozzle group 21GB on the X axis negative direction side. The liquid discharge head 1 according to the present embodiment includes two nozzle groups 21G, but may include only one nozzle group or three or more nozzle groups. The two nozzle groups 21G according to the present embodiment are configured to be parallel to each other. A distance between the nozzles 21 in the Y axis direction of the nozzle group 21G is 84.6 µm. That is, the resolution of the nozzles 21 of each nozzle group 21G is 300 dpi. The nozzles 21 of the first nozzle group 21GA are respectively positioned between the plurality of nozzles 21 of the second nozzle group 21GB in the Y axis direction. That is, the nozzles 21 of the first nozzle group 21GA and the nozzles 21 of the second nozzle group 21GB are shifted from each other in the Y axis direction, and the resolution of the nozzles 21 obtained by combining the two nozzle groups 21G are 600 dpi. Note that the distance between the nozzles 21 of each nozzle group 21G may be appropriately set.

The actuator member 3 includes a silicon substrate 30 in which a plurality of pressure chambers 31 and a plurality of first apertures 32 are formed, a diaphragm 33 positioned on the silicon substrate 30, and a plurality of piezoelectric elements 34 positioned on the diaphragm 33. The silicon substrate 30 is positioned on the nozzle member 2. The actuator member 3 according to the present embodiment has substantially the same shape as the nozzle member 2 in a plan view.

The plurality of pressure chambers 31 are through holes penetrating the silicon substrate 30 in the Z axis direction, and are provided so as to be connected to the plurality of nozzles 21, respectively. The plurality of pressure chambers 31 according to the present embodiment are physically connected to the plurality of nozzles 21, respectively, However, no such limitation is intended. For example, the plurality of pressure chambers 31 may be fluidly connected to the plurality of nozzles 21 via a channel such as a descender, respectively. That is, "connected" is a concept including not only a case of physical connection but also a case of fluid connection. The plurality of pressure chambers 31 are positioned along the Y axis direction, as the same as and/or similarly to the plurality of nozzles 21. The plurality of pressure chambers 31 are positioned such that the longitudinal direction thereof is along the X axis direction and the lateral direction thereof is along the Y axis direction in a plan view. The pressure chamber 31 according to the present embodiment has a substantially rectangular planar shape, but is not limited thereto. For example, the pressure chamber 31 may have a rhombic or circular planar shape. Liquid is stored in the pressure chamber 31. By applying pressure to the liquid in the pressure chamber 31, the liquid is discharged as liquid droplets from the nozzle 21 to the outside.

The plurality of first apertures 32 are through holes penetrating the silicon substrate 30 in the Z axis direction, and are respectively provided so as to be connected to one end portions of the plurality of pressure chambers 31 in the longitudinal direction. The first aperture 32 connected to the pressure chamber 31 positioned on the X axis positive direction side is provided so as to be connected to an end portion of the pressure chamber 31 on the X axis negative direction side. The first aperture 32 connected to the pressure chamber 31 positioned on the X axis negative direction side is provided so as to be connected to an end portion of the pressure chamber 31 on the X axis positive direction side. The liquid is stored in the first aperture 32 in the same or similar manner as in the pressure chamber 31. Since a width of the first aperture 32 in the Y axis direction, that is, a channel width is smaller than that of the pressure chamber 31 in a plan view, the first aperture 32 functions as a so-called throttle.

The diaphragm 33 is positioned on the plurality of pressure chambers 31 and the plurality of first apertures 32.

The plurality of piezoelectric elements 34 are positioned on the diaphragm 33 corresponding to the plurality of pressure chambers 31. The plurality of piezoelectric elements 34 are provided in a one-to-one relationship with the plurality of pressure chambers 31. By applying a voltage to the piezoelectric element 34, the piezoelectric element 34 is displaced. With the displacement of the piezoelectric element 34, the diaphragm 33 positioned on the pressure chamber 31 is also displaced. As a result, pressure is applied to the liquid in the pressure chamber 31. Accordingly, the liquid is discharged from the pressure chamber 31 through the nozzle 21.

The support member 4 is positioned on the actuator member 3. The support member 4 has a predetermined thickness greater than that of the actuator member 3 in the Z axis direction, and has a function of supporting the actuator member 3. The support member 4 includes a plurality of second apertures 41. The support member 4 is made of, for example, silicon.

The plurality of second apertures 41 are through holes penetrating the support member 4 in the Z axis direction, and are provided so as to be connected to the plurality of first apertures 32, respectively. The plurality of second apertures 41 are respectively connected to the plurality of pressure chambers 31 via the plurality of first apertures 32. Similarly to or as the same as the first aperture 32, the second aperture 41 functions as a so-called throttle. The plurality of second apertures 41 are positioned at the center of the support member 4 in the X axis direction in a plan view.

The liquid supply member 5 is positioned on the support member 4. The liquid supply member 5 has substantially the same shape as that of the support member 4 in a plan view. The liquid supply member 5 includes a common channel 51. The liquid supply member 5 is formed of, for example, resin.

The common channel 51 is positioned at the center of the liquid supply member 5 in the X axis direction and is provided along the Y axis direction, in a plan view. Therefore, the common channel 51 is positioned on the plurality of second apertures 41 and is connected to the plurality of second apertures 41. Therefore, the common channel 51 can supply liquid to the plurality of second apertures 41.

The pressure chambers 31, the first apertures 32, the second apertures 41, and the common channel 51 are filled with liquid. When pressure is applied to the pressure chamber 31 by the piezoelectric element 34, liquid is supplied from the pressure chamber 31 to the nozzle 21, and liquid droplets are discharged from the nozzle 21. The pressure chamber 31 is replenished with liquid from the common channel 51 via the first aperture 32 and the second aperture 41.

In the liquid discharge head 1 according to the present embodiment, two apertures, i.e., the first aperture 32 and the second aperture 41 are provided from each pressure chamber 31 to the common channel 51. Accordingly, so-called crosstalk can be reduced in which a pressure wave generated in one pressure chamber 31 propagates to another pressure chamber 31 via the common channel 51.

Note that FIGs. 3 and 4 illustrate an example of the configuration of the liquid discharge head 1, and the liquid discharge head 1 may further include a member other than the members illustrated in FIGs. 3 and 4.

The common channel 51 may include a common channel 51 that supplies liquid to the pressure chamber 31 and a common channel 51 that recovers liquid from the pressure chamber 31. As a result, the liquid discharge head 1 has a circulation function of collecting a part of liquid which is not discharged from the nozzle 21.

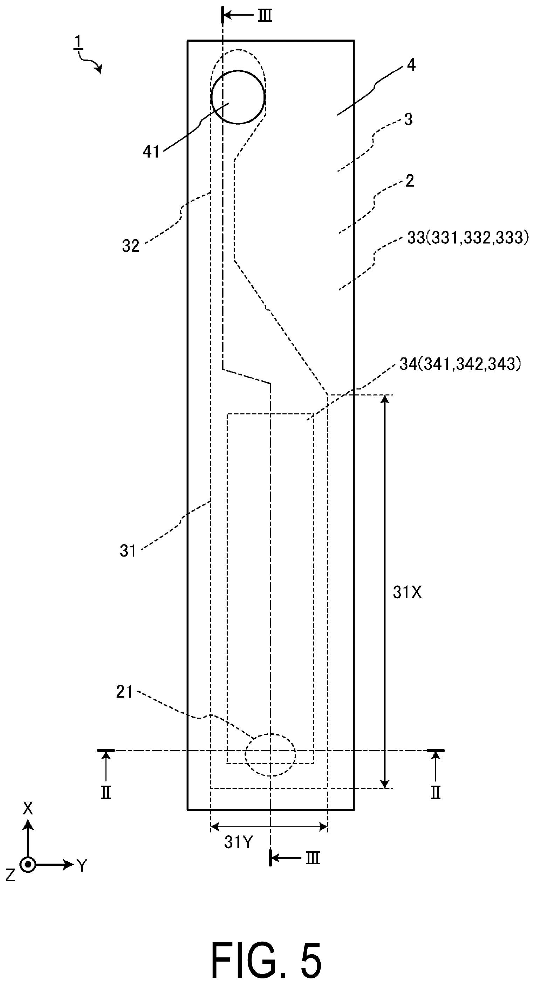

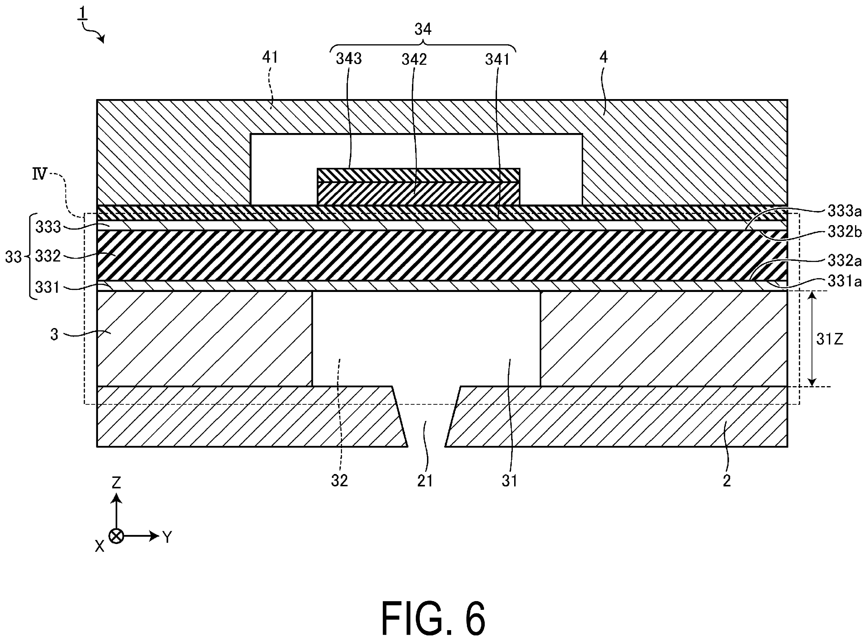

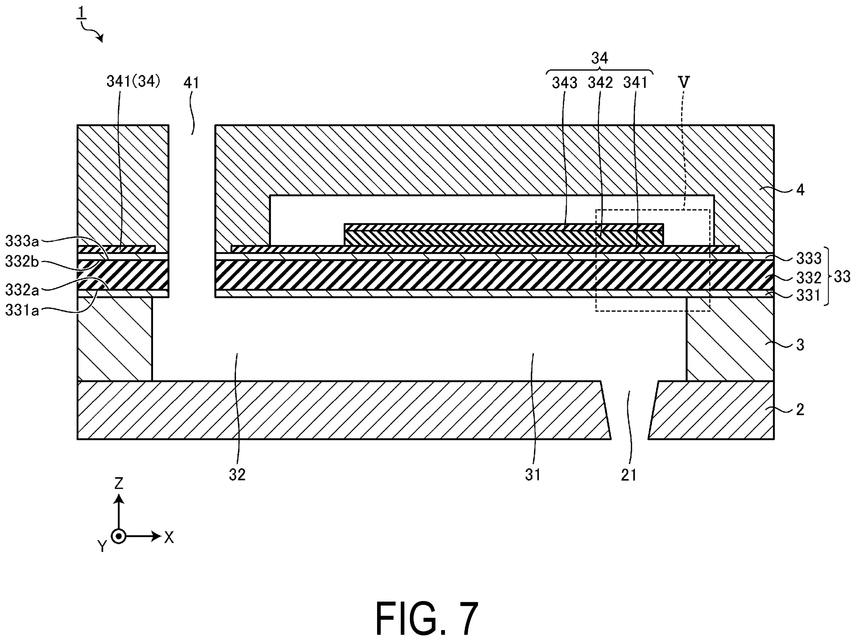

A configuration of the periphery of the pressure chamber 31 according to the present embodiment will be described in detail with reference to FIGs. 5 to 7. FIG. 5 is an enlarged view of a region I illustrated in FIG. 3. FIG. 6 is a cross-sectional view taken along line II-II illustrated in FIG. 5. FIG. 7 is a cross-sectional view taken along line III-III illustrated in FIG. 5. In FIGs. 5 to 7, for ease of understanding the description, the liquid supply member 5 is not illustrated.

A length 31X of the pressure chamber 31 in the longitudinal direction is, for example, 300 to 500 µm. A length 31Y of the pressure chamber 31 in the lateral direction is, for example, 60 to 80 µm. A length 31Z of the pressure chamber 31 in the depth direction is, for example, 50 to 100 µm.

The diaphragm 33 includes a first silicon oxide layer 331, a silicon layer 332 positioned on the first silicon oxide layer 331, and a second silicon oxide layer 333 positioned on the silicon layer 332.

As illustrated in FIGs. 6 and 7, the silicon layer 332 according to the present embodiment is a single layer. The silicon layer 332 is a single layer containing elemental silicon as a main component from a surface in contact with the first silicon oxide layer 331 to a surface in contact with the second silicon oxide layer 333. Here, a single layer refers to a layer made of the same material from a lower surface to an upper surface. The same material does not need to be completely identical, and, for example, the main component may be the same. Note that the main component refers to a component having the highest content among the respective components. That is, the single layer may contain different components as impurities as long as the main components are the same. The silicon layer 332 according to the present embodiment has a reduced number of laminated layers compared to the silicon layer 332 of a multilayer. For this reason, the silicon layer 332 according to the present embodiment can reduce the possibility that variation in thickness occurs.

As illustrated in FIGs. 6 and 7, the first silicon oxide layer 331 and the second silicon oxide layer 333 according to the present embodiment are also single layers. The first silicon oxide layer 331 and the second silicon oxide layer 333 are single layers containing silicon oxide as a main component.

The silicon layer 332 is in direct contact with the first silicon oxide layer 331 and the second silicon oxide layer 333. That is, other layers are not included between the silicon layer 332 and the first silicon oxide layer 331 and between the silicon layer 332 and the second silicon oxide layer 333. In other words, in the diaphragm 33 according to the present embodiment, a lower surface 332a of the silicon layer 332 is in contact with an upper surface 331a of the first silicon oxide layer 331, and an upper surface 332b of the silicon layer 332 is in contact with a lower surface 333a of the second silicon oxide layer 333. For this reason, the diaphragm 33 according to the present embodiment has a reduced number of laminated layers compared to a diaphragm including other layers between the silicon layer 332 and the first silicon oxide layer 331 and between the silicon layer 332 and the second silicon oxide layer 333. For this reason, the diaphragm 33 according to the present embodiment can reduce the possibility that variation in thickness occurs.

As will be described in detail later, the silicon layer 332 of the present embodiment corresponds to a silicon layer of an SOI wafer. The silicon layer 332 is composed of single crystal silicon, like the silicon layer of the SOI wafer. Since the silicon layer 332 is made of single crystal silicon, a Young's modulus thereof is 150 GPa or more and 200 GPa or less. Similarly to the silicon layer of the SOI wafer, the silicon layer 332 has a silicon purity of 99% or more.

The first silicon oxide layer 331 functions as a protective layer. For this reason, since the first silicon oxide layer 331 is positioned between the plurality of pressure chambers 31 and the silicon layer 332, the corrosion resistance against the liquid in the pressure chambers 31 can be enhanced.

The second silicon oxide layer 333 has a function as an insulator. For this reason, since the second silicon oxide layer 333 is positioned between the silicon layer 332 and the plurality of piezoelectric elements 34, leakage of current from the plurality of piezoelectric elements 34 to the silicon layer 332 can be suppressed. Therefore, the liquid discharge head 1 according to the present embodiment can reduce the electrical crosstalk.

The piezoelectric element 34 includes a common electrode 341, a piezoelectric body 342, and an individual electrode 343. In the piezoelectric element 34 according to the present embodiment, the common electrode 341 is positioned on the diaphragm 33, the piezoelectric body 342 is positioned on the common electrode 341, and the individual electrode 343 is positioned on the piezoelectric body 342. However, no such limitation is intended. For example, the arrangement order of the common electrode 341 and the individual electrode 343 from the diaphragm 33 may be reversed. Specifically, the individual electrode 343, the piezoelectric body 342, and the common electrode 341 may be provided in this order on the diaphragm 33. The piezoelectric element 34 may have a cohesion layer such as Ti between the common electrode 341 and the diaphragm 33. The piezoelectric element 34 may have cohesion layers such as LaNiO₃ between the common electrode 341 and the piezoelectric body 342 and between the piezoelectric body 342 and the individual electrode 343.

The common electrode 341 according to the present embodiment is provided in common to the plurality of pressure chambers 31. A thickness of the common electrode 341 according to the present embodiment may be 0.05 µm or more and 1 µm or less. Examples of the constituent material of the common electrode 341 may include a metal material such as Pt.

The piezoelectric body 342 according to the present embodiment is individually provided corresponding to each pressure chamber 31. However, no such limitation is intended. For example, similarly to or as the same as the common electrode 341, the piezoelectric body 342 may be provided in common to the plurality of pressure chambers 31. In the piezoelectric body 342, a portion sandwiched between the individual electrode 343 and the common electrode 341 is polarized in the thickness direction of the Z axis direction. Therefore, for example, when a voltage is applied in the polarization direction of the piezoelectric body 342 by the individual electrode 343 and the common electrode 341, the piezoelectric body 342 contracts in a direction along the diaphragm 33. This contraction is regulated by the diaphragm 33. As a result, the piezoelectric body 342 is displaced to be convex toward the pressure chamber 31 side. With the displacement of the piezoelectric body 342, the diaphragm 33 positioned on the pressure chamber 31 is also displaced. As a result, pressure is applied to the liquid in the pressure chamber 31. A thickness of the piezoelectric body 342 may be set to 0.5 µm or more and 5 µm or less. Examples of the constituent material of the piezoelectric body 342 may include a ceramic material having ferroelectricity such as a Pb(Zr, Ti)O₃-based material, a NaNbO₃-based material, a BaTiO₃-based material, a (BiNa)NbO₃-based material, or a BiNaNB₅O₁₅-based material.

The individual electrode 343 is individually provided corresponding to each pressure chamber 31. A thickness of the individual electrode 343 may be set to 0.05 µm or more and 1 µm or less. Examples of the constituent material of the individual electrode 343 may include a metal material such as Pt.

An embodiment of the diaphragm 33 of the liquid discharge head 1 of the present embodiment will be described in detail.

In the liquid discharge head 1, the thickness of the silicon layer 332 is preferably uniform with respect to the plurality of pressure chambers 31 in order to reduce the possibility that the discharge variation of liquid discharged from the plurality of nozzles 21 or the variation in discharge voltage occurs. Here, the discharge variation of liquid refers to a variation in discharge speed or discharge amount of liquid discharged from the plurality of nozzles 21 caused by non-uniformity in the thickness of the silicon layer 332 with respect to the plurality of pressure chambers 31, when a constant voltage value is applied to the plurality of piezoelectric elements 34. The variation in discharge speed refers to a variation in voltage value caused by non-uniformity in the thickness of the silicon layer 332 with respect to the plurality of pressure chambers 31, when the value of the voltage applied to each piezoelectric element 34 is adjusted so that the liquid is discharged from the plurality of nozzles 21 at a constant discharge speed.

It is difficult to make the thickness of the silicon layer 332 uniform with respect to each of the plurality of pressure chambers 31 in terms of manufacturing. For this reason, in the liquid discharge head of the related art, the non-uniformity in the thickness of the silicon layer with respect to the plurality of pressure chambers causes the discharge variation of liquid discharged from the plurality of nozzles or the variation in discharge voltage. Here, the non-uniformity in the thickness of the silicon layer refers, for example, to a case where a difference between a portion where the thickness of the silicon layer is maximum and a portion where the thickness of the silicon layer is minimum with respect to the plurality of pressure chambers is 0.01 µm or more.

A detailed study conducted by the inventors of the present invention revealed that when the thickness of the silicon layer 332 is excessively large or when the thickness of the silicon layer 332 is excessively small, the possibility that the discharge variation of liquid discharged from the plurality of nozzles 21 or the variation in discharge voltage occurs increases.

The present inventors conducted an evaluation experiment using the liquid discharge head 1 according to the present embodiment. The evaluation experiment is described as follows.

First, values of voltages required to be applied to the piezoelectric elements 34 in order for the liquid discharge head 1 to discharge liquid at the discharge speed of 8 m/s were calculated by simulation with respect to various thicknesses of the silicon layer 332. Based on the calculated values, the slope of the voltage was calculated with respect to the various thicknesses of the silicon layer 332. The slope of the voltage indicates a variation in voltage due to a change in the thickness of the silicon layer 332. Below, the variation in voltage due to a change in the thickness of the silicon layer 332 will be referred to as a "voltage variation". In the liquid discharge head 1 in which the voltage variation is large, the possibility that the discharge variation of the liquid discharged from the plurality of nozzles 21 or the variation in discharge voltage occurs increases.

As evaluation conditions, in FIGs. 5 to 7, the thickness of the common electrode 341 was set to 0.1 µm, the thickness of the piezoelectric body 342 was set to 1 µm, the thickness of the individual electrode 343 was set to 0.1 µm, the length 31X of the pressure chamber 31 in the longitudinal direction was set to 500 µm, the length 31Y of the pressure chamber 31 in the lateral direction was set to 70 µm, and the length 31Z of the pressure chamber 31 in the depth direction was set to 70 µm. The viscosity of the liquid was set to 4.5 mPa·s. The pulse width of the applied voltage was set to AL (Acoustic Length), which is half of the natural vibration period of the liquid discharge head 1.

Note that as a method of discharging the liquid, a so-called pull-ejection method is used. That is, the liquid is discharged by setting the individual electrode 343 to a potential higher than that of the common electrode 341 in advance, setting the individual electrode 343 to the same low potential as that of the common electrode 341 once at the timing of discharge, and setting it to the high potential again after the time AL. At this time, the difference between the high potential and the low potential is a value of the voltage that needs to be applied to the piezoelectric element 34.

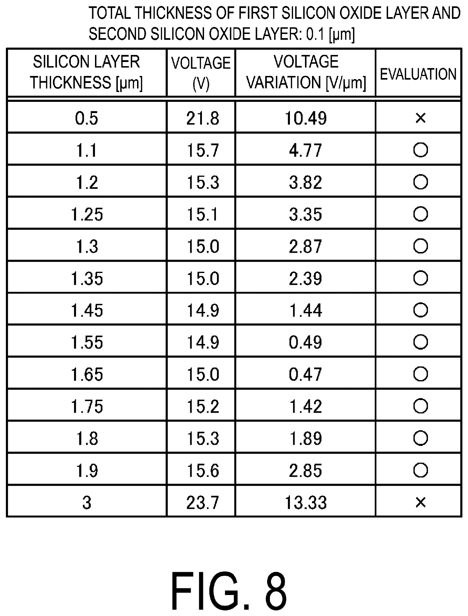

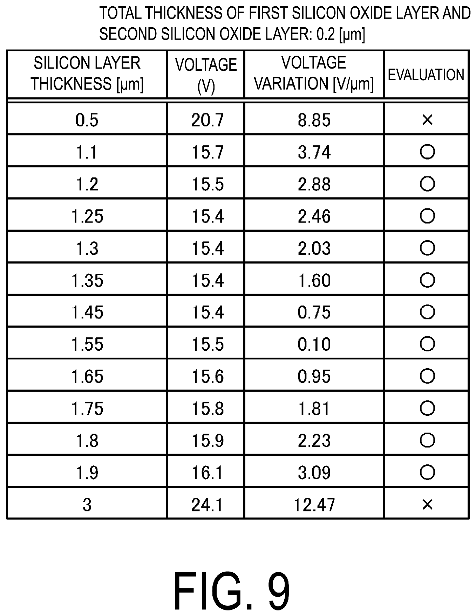

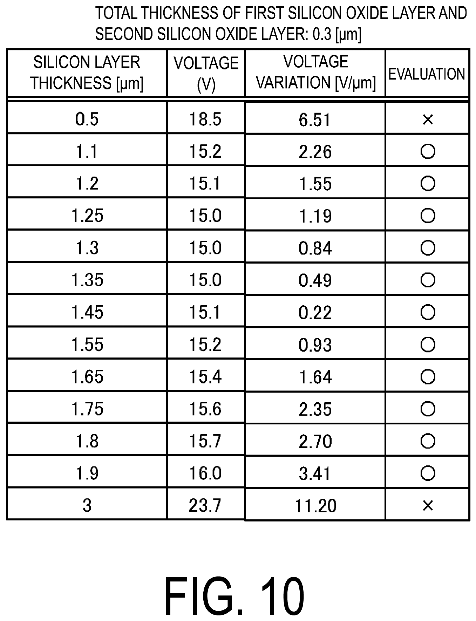

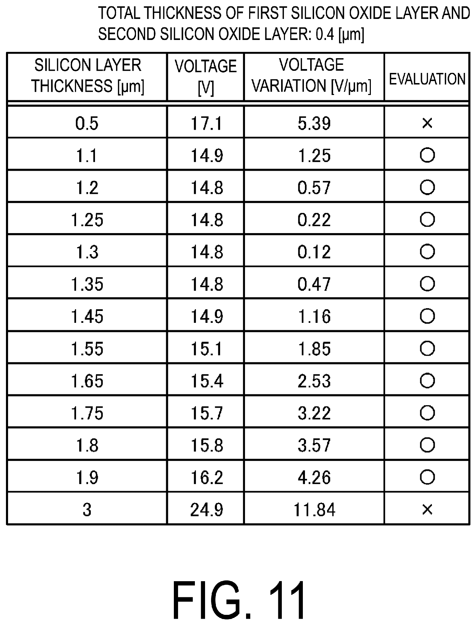

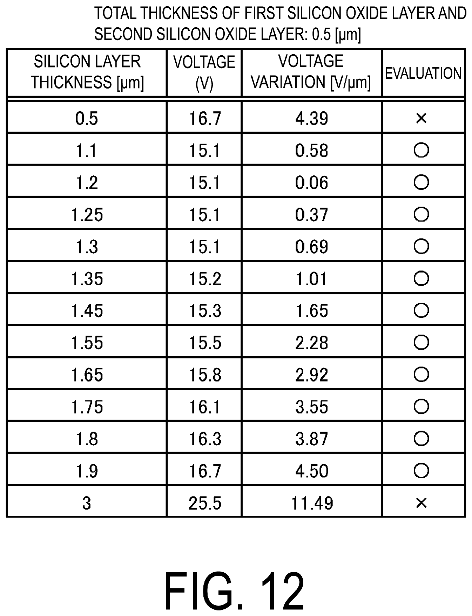

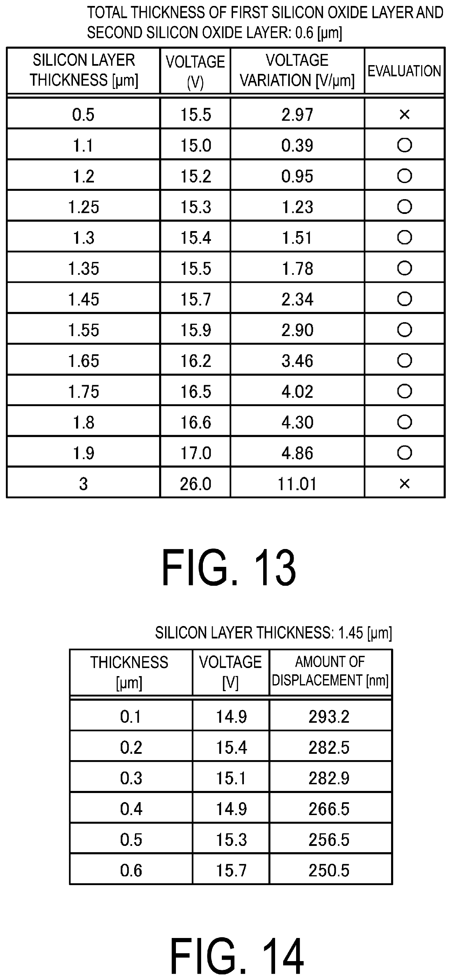

The results of the evaluation experiment are illustrated in FIGs. 8 to 13. FIG. 8 illustrates the result of the evaluation experiment when a total thickness of the first silicon oxide layer 331 and the second silicon oxide layer 333 is 0.1 µm. FIG. 9 illustrates the result of the evaluation experiment when the total thickness of the first silicon oxide layer 331 and the second silicon oxide layer 333 is 0.2 µm. FIG. 10 illustrates the result of the evaluation experiment when the total thickness of the first silicon oxide layer 331 and the second silicon oxide layer 333 is 0.3 µm. FIG. 11 illustrates the result of the evaluation experiment when the total thickness of the first silicon oxide layer 331 and the second silicon oxide layer 333 is 0.4 µm. FIG. 12 illustrates the result of the evaluation experiment when the total thickness of the first silicon oxide layer 331 and the second silicon oxide layer 333 is 0.5 µm. FIG. 13 illustrates the result of the evaluation experiment when the total thickness of the first silicon oxide layer 331 and the second silicon oxide layer 333 is 0.6 µm.

In the results of the evaluation experiment, when the voltage variation was less than 5 V/µm, the evaluation of the discharge variation of liquid or the evaluation of the variation in discharge voltage was "Good", and when the voltage variation was 5 V/µm or more, the evaluation of the variation in liquid discharge or the evaluation of the variation in discharge voltage was "Poor". In FIGs. 8 to 13, the evaluation of the discharge variation of the liquid or the evaluation of the variation in discharge voltage is simply described as "evaluation". This is because when the voltage variation is 5 V/µm or more, the voltage variation is large, and the possibility that the discharge variation of liquid discharged from the plurality of nozzles 21 or the variation in discharge voltage occurs increases.

Note that as illustrated in FIGs. 12 and 13, in the cases where the total thickness of the first silicon oxide layer 331 and the second silicon oxide layer 333 is 0.5 µm and 0.6 µm, when the silicon layer 332 is 0.5 µm thick, the voltage variations are 4.39 V/µm and 2.97 V/µm, respectively, that is, 5 V/µm or less. However, the thickness of the silicon layer 332 is 1.0 µm or less, which is relatively thin. On the other hand, the total thickness of the first silicon oxide layer 331 and the thickness of the second silicon oxide layer 333 is 0.5 µm or more, which is relatively thick. Therefore, it is not easy to stably form the first silicon oxide layer 331 and the second silicon oxide layer 333. For this reason, the variation in thickness of the first silicon oxide layer 331 and the second silicon oxide layer 333 may occur during manufacturing. Therefore, in the liquid discharge head 1 in which the total thickness of the first silicon oxide layer 331 and the thickness of the second silicon oxide layer 333 is 0.5 µm or 0.6 µm and the thickness of the silicon layer 332 is 0.5 µm, the possibility that the discharge variation of liquid discharged from the plurality of nozzles 21 or the variation in discharge voltage occurs increases. For this reason, even when the voltage variation is less than 5 V/µm, the evaluation of the discharge variation of liquid or the evaluation of the variation in discharge voltage is evaluated as "Poor".

As can be seen from FIGs. 8 to 13, the voltage variation rapidly increases when the thickness of the silicon layer 332 is 1.1 µm to 0.5 µm. The voltage variation rapidly increases even when the thickness of the silicon layer 332 is 1.9 µm to 3 µm.

For example, as illustrated in FIG. 9, in the case where the total thickness of the first silicon oxide layer 331 and the second silicon oxide layer 333 is 0.2 µm, the voltage variation is 3.74 V/µm to 3.09 V/µm, i.e., does not largely change, when the silicon layer 332 is 1.1 µm to 1.9 µm thick. On the other hand, the voltage variation rapidly increases from 3.74 V/µm to 8.85 V/µm when the silicon layer 332 is 1.1 µm to 0.5 µm thick. The voltage variation rapidly increases from 3.09 V/µm to 12.47 V/µm when the thickness of the silicon layer 332 is 1.9 µm to 3 µm thick.

The same and/or similar applies to cases where the total thickness of the first silicon oxide layer 331 and the thickness of the second silicon oxide layer 333 is 0.1 µm, 0.3 µm, 0.4 µm, 0.5 µm, or 0.6 µm.

In the diaphragm 33 in which the thickness of the silicon layer 332 is 1.1 µm to 1.9 µm, the variation evaluation is "Good". That is, in the liquid discharge head 1 in which the thickness of the silicon layer 332 is 1.1 µm to 1.9 µm, the possibility that the discharge variation of liquid discharged from the plurality of nozzles 21 or the variation in discharge voltage occurs can be reduced. Even under conditions other than the above-described evaluation conditions, in the liquid discharge head 1 in which the thickness of the silicon layer 332 is 1.1 µm to 1.9 µm, the possibility that the discharge variation of liquid discharged from the plurality of nozzles 21 or the variation in discharge voltage occurs can be reduced.

From the above, in the liquid discharge head 1 according to the present embodiment, the thickness of the silicon layer 332 of the diaphragm 33 is 1.1 µm to 1.9 µm.

Here, the thickness of the silicon layer 332 is an average thickness of the silicon layer 332 only in a portion corresponding to each pressure chamber 31. The average thickness is a value obtained by measuring the thickness of the silicon layer 332 only in a portion corresponding to the pressure chamber 31 at a plurality of points of at least three points and arithmetically averaging the measured values. Note that the plurality of three or more points may be an arithmetic average of measured values at arbitrary three points of the silicon layer 332 only in a portion corresponding to the pressure chamber 31 or may be an arithmetic average of measured values at five points. That is, it is not a concept of obtaining a large number of measurements at 10 points or more. The concept of the thickness of the first silicon oxide layer 331, and the thickness of the second silicon oxide layer 333, the diaphragm 33, and the piezoelectric element 34 is also the same and/or similar as the concept of the thickness of the silicon layer 332 described above.

Here, the thickness of the silicon layer 332 being 1.1 µm to 1.9 µm includes a thickness that falls in the range of 1.1 µm to 1.9 µm when the value at the second decimal place is rounded. For example, when the thickness of the silicon layer 332 is 1.09 µm, rounding the value to the second decimal place gives 1.1 µm, which falls in the range of 1.1 µm to 1.9 µm. For example, when the thickness of the silicon layer 332 is 1.92 µm, rounding the value to the second decimal place gives 1.9 µm, which falls in the range of 1.1 µm to 1.9 µm.

In each of the cases where the total thickness of the first silicon oxide layer 331 and second silicon oxide layer 333 is 0.1 µm, 0.2 µm, 0.3 µm, 0.4 µm, 0.5 µm, and 0.6 µm, when the silicon layer 332 is 1.3 µm to 1.55 µm thick, the voltage variation is less than 3 V/µm. Therefore, in the liquid discharge head 1 according to the present embodiment, the thickness of the silicon layer 332 is more preferably 1.3 µm to 1.55 µm.

In the liquid discharge head 1 according to the present embodiment, the present inventors have further studied in detail the an amount of displacement of the diaphragm 33, in addition to the discharge variation of liquid discharged from the plurality of nozzles 21 or the variation in discharge voltage. In the above description, the values of voltages required to be applied to the piezoelectric elements 34 in order for the liquid discharge head 1 to discharge liquid at the discharge speed of 8 m/s were calculated by simulation. The present inventors simultaneously calculated the amount of displacement of the diaphragm 33 by simulation when the voltage was applied to the piezoelectric element 34. Note that, here, the amount of displacement of the diaphragm 33 was calculated when the thickness of the silicon layer 332 was 1.45 µm. Here, the amount of displacement refers to a maximum amount of displacement of the diaphragm 33 when a voltage is applied to the piezoelectric element 34.

The evaluation conditions are the same as and/or similar to the evaluation conditions of the simulation in FIGs. 8 to 13.

The calculated amounts of displacement of the diaphragm 33 are illustrated in FIG. 14. FIG. 14 illustrates the voltages and the amounts of displacement in the diaphragm 33 in which the total thickness of the first silicon oxide layer 331 and the second silicon oxide layer 333 is 0.1 µm, 0.2 µm, 0.3 µm, 0.4 µm, 0.5 µm, and 0.6 µm. In FIG. 14, the total thickness of the first silicon oxide layer 331 and the second silicon oxide layer 333 is simply referred to as "total thickness".

As the amount of displacement of the diaphragm 33 increases, the discharge amount of liquid discharged from the nozzles 21 increases. When the total thickness of the first silicon oxide layer 331 and the second silicon oxide layer 333 is 0.3 µm or less, the amount of displacement of the diaphragm 33 is 280 nm or more, which is relatively large.

Therefore, in the liquid discharge head 1 including the diaphragm 33 in which the total thickness of the first silicon oxide layer 331 and the second silicon oxide layer 333 is 0.3 µm or less, the discharge amount of liquid discharged from the nozzles 21 is large. When the total thickness of the first silicon oxide layer 331 and the second silicon oxide layer 333 is 0.3 µm or less and the silicon layer 332 is 1.3 µm to 1.8 µm thick, the voltage variation is less than 3 V/µm.

Therefore, in the liquid discharge head 1 including the diaphragm 33 in which the total thickness of the first silicon oxide layer 331 and the second silicon oxide layer 333 is 0.3 µm or less and the silicon layer 332 is 1.3 µm to 1.8 µm thick, the discharge amount of liquid discharged from the plurality of nozzles 21 is large, and the possibility that the discharge variation of liquid discharged from the plurality of nozzles 21 or the variation in discharge voltage occurs can be reduced. Therefore, in the liquid discharge head 1 according to the present embodiment, it is preferable that the total thickness of the first silicon oxide layer 331 and the thickness of the second silicon oxide layer 333 be 0.3 µm or less, and the silicon layer 332 be 1.3 µm to 1.8 µm thick. In the diaphragm 33 in which the total thickness of the first silicon oxide layer 331 and the thickness of the second silicon oxide layer 333 is less than 0.1 µm, it is difficult to obtain effects such as corrosion resistance against the liquid in the pressure chamber 31 or reduction in the electrical crosstalk. Therefore, the total thickness of the first silicon oxide layer 331 and the second silicon oxide layer 333 is preferably 0.1 µm or more.

On the other hand, in the diaphragm 33 in which the total thickness of the first silicon oxide layer 331 and the second silicon oxide layer 333 is greater than 0.3 µm, the amount of displacement is smaller than that of the diaphragm 33 in which the total thickness is 0.3 µm or less. This means that the diaphragm 33 in which the total thickness of the first silicon oxide layer 331 and the second silicon oxide layer 333 is larger than 0.3 µm has high rigidity. Therefore, in the diaphragm 33 in which the total thickness of the first silicon oxide layer 331 and the second silicon oxide layer 333 is greater than 0.3 µm, the possibility that deterioration due to displacement occurs can be reduced. When the total thickness of the first silicon oxide layer 331 and the second silicon oxide layer 333 of the diaphragm 33 is greater than 0.3 µm and the silicon layer 332 is 1.1 µm to 1.55 µm thick, the voltage variation is less than 3 V/µm.

Therefore, in the liquid discharge head 1 including the diaphragm 33 in which the total thickness of the first silicon oxide layer 331 and the second silicon oxide layer 333 is greater than 0.3 µm and the silicon layer 332 is 1.1 µm to 1.55 µm thick, the possibility that the diaphragm 33 deteriorates can be reduced, and the possibility that the discharge variation of liquid discharged from the plurality of nozzles 21 or the variation in discharge voltage occurs can be reduced. Therefore, in the liquid discharge head 1 according to the present embodiment, it is preferable that the total thickness of the first silicon oxide layer 331 and the second silicon oxide layer 333 be greater than 0.3 µm, and the silicon layer 332 be 1.1 µm to 1.55 µm thick.

When the total thickness of the first silicon oxide layer 331 and the second silicon oxide layer 333 of the diaphragm 33 is 0.5 µm or more and the silicon layer 332 is 1.1 µm to 1.35 µm thick, the voltage variation is less than 2 V/µm.

Therefore, in the liquid discharge head 1 including the diaphragm 33 in which the total thickness of the first silicon oxide layer 331 and the second silicon oxide layer 333 is 0.5 µm or more and the silicon layer 332 is 1.1 µm to 1.35 µm thick, the possibility that the discharge variation of liquid discharged from the plurality of nozzles 21 or the variation in discharge voltage occurs can be further reduced. Therefore, in the liquid discharge head 1 according to the present embodiment, it is more preferable that the total thickness of the first silicon oxide layer 331 and the second silicon oxide layer 333 be 0.5 µm or more, and the silicon layer 332 be 1.1 µm to 1.35 µm thick.

In the diaphragm 33 in which the total thickness of the first silicon oxide layer 331 and the second silicon oxide layer 333 is greater than 1.0 µm, it is difficult to obtain an amount of displacement that allows liquid to be discharged. Therefore, it is preferable that the total thickness of the first silicon oxide layer 331 and the second silicon oxide layer 333 be 1.0 µm or less.

Note that the evaluation of the voltage variation illustrated in FIGs. 8 to 13 is performed when the length 31Y of the pressure chamber 31 in the lateral direction is 70 µm, and the resolution of the plurality of nozzles 21 is assumed to be 300 dpi. If the resolution of the plurality of nozzles 21 is higher than 1200 dpi, the length 31Y of the pressure chamber 31 in the lateral direction becomes small, making it difficult to obtain an amount of displacement by which the diaphragm 33 can discharge the liquid. Therefore, the resolution of the plurality of nozzles 21 is preferably 1200 dpi or lower. When the resolution of the plurality of nozzles 21 is lower than 150 dpi, the resolution is low, making it difficult to obtain good image quality. Therefore, the resolution of the plurality of nozzles 21 is preferably 150 dpi or higher.

In the liquid discharge head 1, in the diaphragm 33 in which the difference between the portion where the thickness of the silicon layer 332 is the maximum and the portion where the thickness of the silicon layer 332 is the minimum is 0.01 µm or more, the thickness of the silicon layer 332 becomes non-uniform with respect to the plurality of pressure chambers 31, and thus the possibility that the discharge variation of liquid discharged from the plurality of nozzles 21 or the variation in discharge voltage occurs increases. Therefore, the silicon layer 332 is more preferably 1.1 µm to 1.9 µm thick.

The thickness of the piezoelectric element 34 according to the present embodiment is 1.2 µm. The thickness of the diaphragm 33 according to the present embodiment is 1.65 µm. That is, in the liquid discharge head 1 according to the present embodiment, the thickness of the piezoelectric element 34 is smaller than the thickness of the diaphragm 33. Accordingly, the possibility that the amount of displacement of the diaphragm 33 is reduced due to the thickness of the piezoelectric element 34 being large can be reduced.

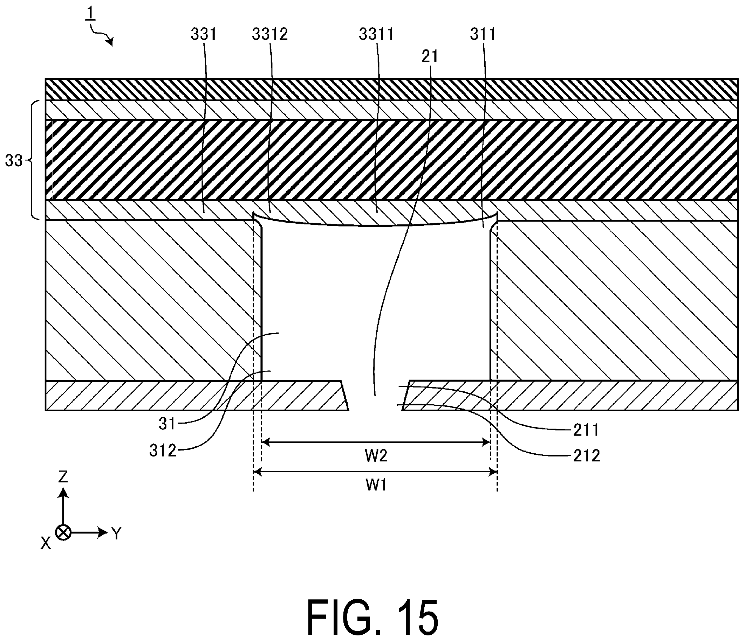

A configuration of the pressure chamber 31 and the periphery of the pressure chamber 31 according to the present embodiment and will be described in detail with reference to FIG. 15. FIG. 15 is an enlarged view of a region IV illustrated in FIG. 6.

The first silicon oxide layer 331 has a central portion 3311 and end portions 3312 on both sides of the central portion 3311 in a portion corresponding to the pressure chamber 31. In the first silicon oxide layer 331, deterioration is more likely to occur in the central portion 3311 because the amount of displacement of the central portion 3311 is greater than those of the end portions 3312. Therefore, in the first silicon oxide layer 331 according to the present embodiment, the central portion 3311 is configured to be thicker than the end portions 3312. As a result, in the liquid discharge head 1 according to the present embodiment, the rigidity of the central portion 3311 can be increased, and the possibility that the central portion 3311 and the diaphragm 33 deteriorate can be reduced.

The central portion 3311 has a convex curved surface in a cross-sectional view. Since the central portion 3311 has the convex curved surface, the stress can be alleviated by the convex curved surface, and the possibility that the diaphragm 33 deteriorates can be further reduced.

By the displacement of the diaphragm 33, the liquid in the pressure chamber 31 is pressurized, and the liquid is discharged from the nozzle 21 connected to the pressure chamber 31. In a cross-sectional view, the pressure chamber 31 according to the present embodiment has a pair of a first end portion 311 and a second end portion in a height direction, that is, the Z axis direction. The first end portion 311 is in contact with the diaphragm 33, and the second end portion 312 is in contact with the nozzle 21. A width W1 of the first end portion 311 is larger than a width W2 of the second end portion 312. Since the width W1 of the first end portion 311 is large, the amount of displacement of the diaphragm 33 can be increased. Since the width W2 of the second end portion 312 is small, the strength of a portion between a pressure chamber 31 and a pressure chamber 31 adjacent to the pressure chamber 31 can be increased. Therefore, in the liquid discharge head 1 according to the present embodiment, the displacement of the diaphragm 33 can be efficiently used to discharge liquid droplets through a pressure wave.

The pressure chamber 31 includes a portion whose width gradually increases toward the first end portion. For this reason, in the liquid discharge head 1 according to the present embodiment, the displacement of the diaphragm 33 can be efficiently used to discharge liquid droplets through a pressure wave as compared with a case where the width increases stepwise toward the first end portion 311.

In a cross-sectional view, the nozzle 21 according to the present embodiment has a pair of a third end portion 211 and a fourth end portion 212 in the height direction, that is, the Z axis direction. The third end portion 211 is in contact with the pressure chamber 31, and the fourth end portion 212 is spaced apart from the pressure chamber 31. A width of the third end portion 211 is greater than a width of the fourth end portion 212. Therefore, in the liquid discharge head 1, the pressure is easily transmitted to the nozzle 21 by the displacement of the diaphragm 33. Therefore, in the liquid discharge head 1 according to the present embodiment, the displacement of the diaphragm 33 can be efficiently used to discharge liquid droplets through a pressure wave.

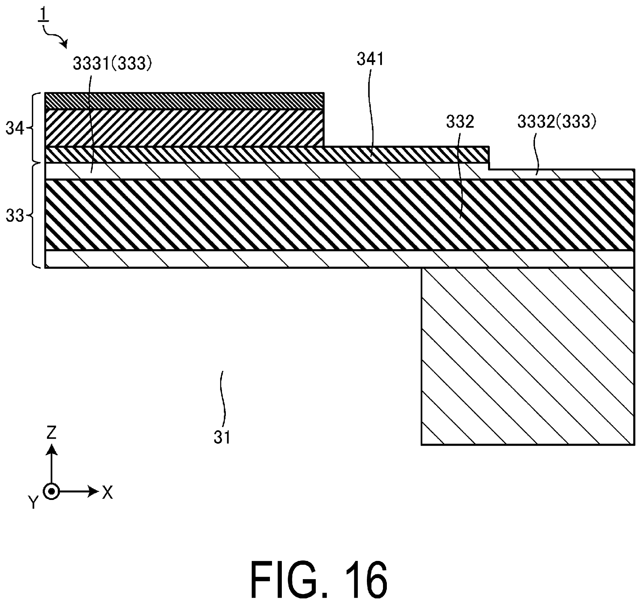

A configuration of the pressure chamber 31 and the periphery of the pressure chamber 31 according to the present embodiment will be described in detail with reference to FIG. 16. FIG. 16 is an enlarged view of a region V illustrated in FIG. 7.

As described above, the second silicon oxide layer 333 can reduce leakage of current from the plurality of piezoelectric elements 34 to the silicon layer 332. The liquid discharge head 1 according to the present embodiment includes a portion in which a portion 3331 of the second silicon oxide layer 333 positioned below the common electrode 341 is thicker than a portion 3332 of the second silicon oxide layer 333 not positioned below the common electrode 341. For this reason, in the liquid discharge head 1 according to the present embodiment, leakage of current from the plurality of piezoelectric elements 34 to the silicon layer 332 can be reduced. That is, the liquid discharge head 1 according to the present embodiment can further reduce the electrical crosstalk.

The thickness of the portion 3331 of the second silicon oxide layer 333 positioned below the common electrode 341 is preferably 1.05 times or more the thickness of the portion 3332 of the second silicon oxide layer 333 not positioned below the common electrode 341.

Since the amount of displacement is large in the diaphragm 33 positioned on the pressure chamber 31, the possibility that the diaphragm 33 deteriorates increases. The portion 3331 of the second silicon oxide layer 333 according to the present embodiment positioned below the common electrode 341 is positioned on the silicon layer 332 so as to cover the pressure chamber 31 in a plan view. For this reason, since the thickness of the portion 3331 of the second silicon oxide layer 333 positioned below the common electrode 341 is large, the rigidity of the diaphragm 33 on the pressure chamber 31 can be increased, and the possibility that the diaphragm 33 deteriorates can be reduced.

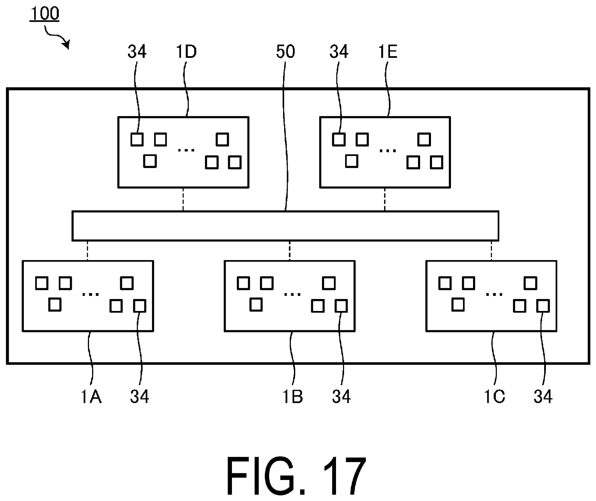

A configuration example of the head module 100 according to the present embodiment will be described with reference to FIG. 17. FIG. 17 is a block diagram illustrating a configuration example of the head module 100.

The head module 100 includes five liquid discharge heads 1A, 1B, 1C, 1D, and 1E, and a storage unit 50. The storage unit 50 for each of the liquid discharge heads 1A, 1B, 1C, 1D, and 1E stores a voltage value that is commonly applied to the plurality of piezoelectric elements 34. The voltage value is common to the plurality of piezoelectric elements 34 in each of the liquid discharge heads 1A, 1B, 1C, 1D, and 1E. Therefore, a common voltage value is applied to the plurality of piezoelectric elements 34 included in each of the liquid discharge heads 1A, 1B, 1C, 1D, and 1E based on data transmitted from the controller 109. The storage unit 50 according to the present embodiment stores a value and a pulse width of voltage that is commonly applied to the plurality of piezoelectric elements 34, and thus, a common pulsed voltage waveform can be transmitted to the plurality of piezoelectric elements 34 included in each of the liquid discharge heads 1A, 1B, 1C, 1D, and 1E.

Although one storage unit 50 according to the present embodiment is provided for the head module 100, a plurality of storage units 50 may be provided. One storage unit 50 may be provided for each of the five liquid discharge heads 1A, 1B, 1C, 1D, and 1E. The storage unit 50 is provided in an IC such as a drive IC, for example.

The storage unit 50 may store one voltage value or a plurality of voltage values for each of the liquid discharge heads 1A, 1B, 1C, 1D, and 1E. When the storage unit 50 stores a plurality of voltage values for each of the liquid discharge heads 1A, 1B, 1C, 1D, and 1E, for example, a discharge amount of liquid to be discharged can be adjusted. When the storage unit 50 stores a plurality of voltage values for each of the liquid discharge heads 1A, 1B, 1C, 1D, and 1E, at least one voltage value may be common to the plurality of piezoelectric elements 34 in each of the liquid discharge heads 1A, 1B, 1C, 1D, and 1E.

In the head module 100, a common voltage value is applied to the plurality of piezoelectric elements 34 included in each of the liquid discharge heads 1A, 1B, 1C, 1D, and 1E. Therefore, in each of the liquid discharge heads 1A, 1B, 1C, 1D, and 1E, it is necessary to further reduce the possibility that the discharge variation of liquid discharged from the plurality of nozzles 21 occurs. For this reason, in the head module 100, the thicknesses of the silicon layers 332 of the respective liquid discharge heads 1A, 1B, 1C, 1D, and 1E are more preferably 1.1 µm to 1.9 µm.

The voltage values stored in the storage unit 50 are different among the plurality of liquid discharge heads 1A, 1B, 1C, 1D, 1E. In the head module 100 according to the present embodiment, the voltage values stored in the storage unit 50 are adjusted so that the discharge speeds of liquid discharged from the liquid discharge heads 1A, 1B, 1C, 1D, and 1E are the same. In the head module 100, for example, the voltage values stored in the storage unit 50 may be adjusted so that the printing density is the same among the liquid discharge heads 1A, 1B, 1C, 1D, and 1E. Therefore, it is necessary to further reduce the possibility that variation in voltage occurs among the liquid discharge heads 1A, 1B, 1C, 1D, and 1E. For this reason, in the head module 100, the thicknesses of the silicon layers 332 of the respective liquid discharge heads 1A, 1B, 1C, 1D, and 1E are more preferably 1.1 µm to 1.9 µm.

The average value of the thicknesses of the silicon layers 332 differ by 0.01 µm or more among the plurality of liquid discharge heads 1A, 1B, 1C, 1D, and 1E. In such a head module 100, since the thicknesses of the silicon layers 332 are not uniform among the liquid discharge heads 1A, 1B, 1C, 1D, and 1E, it is necessary to reduce the possibility that the discharge variation of liquid discharged from the plurality of nozzles 21 or the variation in discharge voltage occurs. For this reason, in the head module 100, the thicknesses of the silicon layers 332 of the respective liquid discharge heads 1A, 1B, 1C, 1D, and 1E are more preferably 1.1 µm to 1.9 µm.

Finally, a method of manufacturing the liquid discharge head 1 will be described.

First, the nozzle member 2, the actuator member 3, the support member 4, and the liquid supply member 5 are each prepared. The support member 4 is bonded onto the actuator member 3, and the nozzle member 2 is bonded under the actuator member 3. The liquid supply member 5 is bonded to the support member 4. The order of bonding is not limited. Note that examples of the bonding between the nozzle member 2 and the actuator member 3 and the bonding between the actuator member 3 and the support member 4 may include ambient temperature bonding and metal bonding. As the bonding between the support member 4 and the liquid supply member 5, a bonding method using an adhesive may be exemplified.

A method for manufacturing the actuator member 3 will be described.

The actuator member 3 can be manufactured by performing film formation and etching on an SOI wafer. The SOI wafer is a substrate formed of a silicon layer, a silicon oxide layer positioned on the silicon layer, and a silicon layer positioned on the silicon oxide film. Here, the silicon layer positioned on a lower side of the SOI wafer corresponds to the silicon substrate 30. The silicon oxide layer of the SOI wafer corresponds to the first silicon oxide layer 331 of the diaphragm 33. The silicon layer positioned on an upper side of the SOI wafer corresponds to the silicon layer 332 of the diaphragm 33. The silicon layer 332 has a silicon purity of 99% or more, similarly to the silicon layer of the SOI wafer. The silicon layer 332 is composed of single crystal silicon, similarly to the silicon layer of the SOI wafer.

Since the silicon layer 332 is made of single crystal silicon, a Young's modulus thereof is 150 GPa or more and 200 GPa or less. The Young's modulus can be measured by, for example, a nanoindentation method. Compared with a silicon layer whose Young's modulus is greater than 200 GPa, a silicon layer whose Young's modulus is 200 GPa or less is displaced by small energy. The Young's modulus of the silicon layer in the diaphragm 33 according to the present embodiment is 200 GPa or less. For this reason, the diaphragm 33 according to the present embodiment is displaced by smaller energy than a diaphragm having a silicon layer whose Young's modulus is greater than 200 GPa. Therefore, in the liquid discharge head 1 according to the present embodiment, the voltage applied to the piezoelectric element, which is necessary for displacing the diaphragm 33, can be reduced.

The diaphragm 33 is formed by forming a silicon oxide layer, which corresponds to the second silicon oxide layer 333 of the diaphragm 33, on a surface of the silicon layer positioned on the upper side of the SOI wafer by, for example, a plasma CVD method or thermal oxidation. As a result, for example, as illustrated in FIGs. 6 and 7, the diaphragm 33 has a three-layered configuration of the first silicon oxide layer 331, the silicon layer 332, and the second silicon oxide layer 333. That is, the diaphragm 33 includes the first silicon oxide layer 331 as a single layer, the silicon layer 332 as a single layer, and the second silicon oxide layer 333 as a single layer.

The diaphragm 33 according to the present embodiment is formed such that the thickness of the first silicon oxide layer 331 is 0.1 µm, the thickness of the silicon layer 332 is 1.45 µm, and the thickness of the second silicon oxide layer 333 is 0.1 µm.

The silicon layer 332 according to the present embodiment corresponds to a silicon layer of an SOI wafer. The silicon layer 332 is composed of single crystal silicon, like the silicon layer of the SOI wafer. Single crystal silicon has a crystalline structure in which atoms are regularly arrayed. Therefore, the silicon oxide layer formed on the surface of the single crystal silicon tends to have a stable crystalline structure. That is, since the second silicon oxide layer 333 according to the present embodiment is formed on the silicon layer 332 made of single crystal silicon, the second silicon oxide layer has a stable crystalline structure. Specifically, the stable crystalline structure is a crystalline structure excellent in strength, toughness, insulating properties, moisture resistance, and the like. Note that the silicon layer 332 is not limited to single crystal silicon and may be made of polycrystalline silicon.

The common electrode 341 is formed on the diaphragm 33 by, for example, forming a film of Pt by sputtering and then removing an unnecessary portion by etching.

The piezoelectric body 342 is formed on the common electrode 341 by, for example, forming a film of Pb(Zr, Ti)O₃ by sputtering and then removing an unnecessary portion by etching.

The individual electrode 343 is formed on the piezoelectric body 342 by, for example, forming a film of Pt by sputtering and then removing an unnecessary portion by etching.

The pressure chamber 31 and the first aperture 32 are formed by, for example, etching the silicon layer positioned on the lower side of the SOI wafer. At this time, the silicon oxide layer of the SOI wafer serves as an etching stop layer.

The actuator member 3 is manufactured in this way.

### REFERENCE SIGNS

1, 1A, 1B, 1C, 1D, 1E: Liquid discharge head
21: Nozzle
31: Pressure chamber
311: First end portion
312: Second end portion
33: Diaphragm
331: First silicon oxide layer
332: Silicon layer
333: Second silicon oxide layer
34: Piezoelectric element
341: Common electrode
10: Printer (recording device)
50: Storage unit
100: Head module
109: Controller

## Claims

1. A liquid discharge head comprising:
a plurality of pressure chambers;
a plurality of nozzles respectively connected to the plurality of pressure chambers;
a diaphragm positioned on the plurality of pressure chambers; and
a plurality of piezoelectric elements positioned on the diaphragm corresponding to the plurality of pressure chambers, wherein
the diaphragm comprises
a first silicon oxide layer,
a silicon layer as a single layer positioned on the first silicon oxide layer and having a thickness of 1.1 µm to 1.9 µm, and
a second silicon oxide layer positioned on the silicon layer as a single layer.

2. The liquid discharge head according to claim 1, wherein
the silicon layer as a single layer is in direct contact with the first silicon oxide layer and the second silicon oxide layer.

3. The liquid discharge head according to claim 1, wherein
the silicon layer as a single layer is composed of single crystal silicon.

4. The liquid discharge head according to claim 1, wherein
a total thickness of the first silicon oxide layer and the second silicon oxide layer is 0.3 µm or less, and
the silicon layer as a single layer has a thickness of 1.3 µm to 1.8 µm.

5. The liquid discharge head according to claim 1, wherein
a total thickness of the first silicon oxide layer and the second silicon oxide layer is greater than 0.3 µm, and
the silicon layer as a single layer has a thickness of 1.1 µm to 1.55 µm.

6. The liquid discharge head according to claim 1, wherein
a total thickness of the first silicon oxide layer and the second silicon oxide layer is 0.5 µm or more, and
the silicon layer as a single layer has a thickness of 1.1 µm to 1.35 µm.

7. The liquid discharge head according to claim 1, wherein
the plurality of nozzles have a resolution of 150 dpi to 1200 dpi.

8. The liquid discharge head according to claim 1, wherein
the silicon layer as a single layer has a difference of 0.01 µm or more between a portion having a maximum thickness and a portion having a minimum thickness.

9. The liquid discharge head according to claim 1, wherein
a thickness of the piezoelectric element is smaller than a thickness of the diaphragm.

10. The liquid discharge head according to claim 1, wherein
the first silicon oxide layer is thicker at a central portion than at an end portion in a portion corresponding to the pressure chamber.

11. The liquid discharge head according to claim 1, wherein in a cross-sectional view,
the pressure chamber comprises a pair of first and second end portions in a height direction,
the first end portion is in contact with the diaphragm,
the second end portion is in contact with the nozzle, and
a width of the first end portion is greater than a width of the second end portion.

12. The liquid discharge head according to claim 1, wherein
the plurality of piezoelectric elements comprise a common electrode on the diaphragm, the common electrode being common to the plurality of pressure chambers, and
a thickness of a portion of the second silicon oxide layer positioned below the common electrode is larger than a thickness of a portion of the second silicon oxide layer not positioned below the common electrode.

13. A head module comprising:
the liquid discharge head according to claim 1; and
a storage unit in which a value of a voltage commonly applied to the plurality of piezoelectric elements in the liquid discharge head is stored.

14. The head module according to claim 13, wherein
a plurality of the liquid discharge heads are provided, and
the value of the voltage is different among the plurality of liquid discharge heads.

15. The head module according to claim 14, wherein
an average value of thickness of the silicon layer as a single layer differs by 0.01 µm or more among the plurality of liquid discharge heads.

16. A recording device comprising:
the liquid discharge head according to any one of claims 1 to 12;
a moving unit configured to relatively move the liquid discharge head and a recording medium; and
a controller configured to control the moving unit.

17. A recording device comprising:
the head module according to any one of claims 13 to 15;
a moving unit configured to relatively move the head module and a recording medium; and
a controller configured to control the moving unit.
